# FASCICULE DE BREVET EUROPEEN

(11) **EP 3 008 983 B1**
(45) Date de publication et mention de la délivrance du brevet: **08.08.2018**
(21) Numéro de dépôt: 14736656.1
(22) Date de dépôt: 14.06.2014
(51) Int. Cl.: H05K 7/14, H05K 7/20

(54) **PROCÉDÉ D'INTÉGRATION DE MODULE D'INTERCONNEXION AMOVIBLE DANS UN MEUBLE, MEUBLE AINSI EQUIPÉ ET AÉRONEF COMPORTANT UNE BAIE CONSTITUÉE DE TELS MEUBLES**
VERFAHREN ZUR INTEGRATION EINES LÖSBAREN VERBINDUNGSMODUL IN EINEM SCHRANK, SCHRANK DAMIT UND FLUGZEUG MIT EINEM BAUGRUPPENTRÄGER AUS SOLCHEN SCHRÄNKEN
METHOD FOR INTEGRATING A DETACHABLE INTERCONNECTION MODULE IN A CABINET, CABINET THUS FITTED, AND AIRCRAFT COMPRISING A BAY CONSISTING OF SUCH CABINETS

(30) Priorité: 15.06.2013 FR 1355612
(43) Date de publication de la demande: 20.04.2016
(73) Titulaire: LATELEC, FR-31676 Labege (FR)
(72) Inventeur: MORRISON, Damien, F-31200 Toulouse (FR); PUERTOLAS, Bastien, F-31320 Castanet Toulousan (FR); DELAME, Cyrille, F-31650 Saint Orens (FR); BOUCOURT, Gerard, F-31180 Rouffiac Tolosan (FR); GRIMM, Martial, F-31150 Fenouillet (FR); AMALRIC, Bernard, F-31240 L'Union (FR); BANASIAK, Vincent, F-31400 Toulouse (FR); BERNADAC, Jean Charles, F-31320 Castanet Tolosan (FR); ESCALAUP, Olivier, F-31520 Raimonville Saint Agne (FR); GRI, Philippe, F-31180 Saint Genies Bellevue (FR)
(74) Mandataire: Junca, Eric
(86) Numéro de dépôt international: PCT/EP2014/062487
(87) Numéro de publication internationale: WO 2014/198957

(56) Documents cités:
- FR-A1- 2 822 130
- FR-A1- 2 927 222
- FR-A1- 2 977 446
- FR-A1- 2 977 447

## Description

### DOMAINE TECHNIQUE

L'invention se rapporte à un procédé d'intégration d'un module d'interconnexion d'harnais de câblage avionique dans un meuble électronique de logement et de connexion de modules électroniques. L'invention se rapporte également à un meuble électronique équipé d'au moins un module d'interconnexion de ce type, ainsi qu'à un aéronef comportant une baie avionique constituée d'un ensemble de meubles de ce type pour connecter les équipements électriques/électroniques via des câblages répartis dans cet aéronef.

L'invention concerne le domaine de l'avionique et s'applique de manière générale aux regroupements du matériel de traitement et de gestion électrique/électronique des équipements d'un aéronef : coeurs électriques, calculateurs, modules de puissance, centrales inertielles, commandes et fonctions connexes (convertisseurs, etc.). Le matériel, qui comporte en général des cartes et composants électroniques, est conditionné sous forme d'une multitude de modules électroniques - appelés « blades » en terminologie anglaise - intégrés dans des meubles. L'ensemble de ces meubles constitue une baie avionique.

Les meubles se présentent sous la forme de boitiers parallélépipédiques équipés de moyens de logement des modules électroniques en position verticale, parallèlement les unes aux autres. Ces meubles sont équipés d'ouvertures de ventilation des modules électroniques et d'une interface de connexion afin de coupler la baie avionique à différents équipements opérationnels de l'aéronef selon une architecture réseau, via des harnais de faisceaux de câbles électriques/optiques ainsi qu'un réseau d'alimentation électrique de bord. En général, les équipements opérationnels sont répartis le long du fuselage et dans les ailes de l'appareil.

La baie avionique est de préférence localisée dans la partie inférieure avant du fuselage, sous le cockpit, dans des conditions de pression et de température contrôlées : pression ambiante stable (zone pressurisée de l'aéronef), et température maîtrisée. Des structures mécaniques, connues sous le nom de "chaises", sont habituellement prévues dans la zone d'accueil de la baie pour assurer un maintien des meubles en liaison avec leur environnement immédiat et aménager un passage pour les flux d'air de ventilation de ces meubles.

Chaque chaise est constituée principalement d'une plaque horizontale de support équipée de moyens de verrouillage, d'une plaque arrière ajourée - pour permettre le passage des faisceaux de câbles - et d'entretoises latérales. Une telle installation est définie par une norme aéronautique internationale : ARINC600. Un assemblage conforme à cette norme est par exemple décrit dans le document de brevet US 6 797 879.

### ÉTAT DE LA TECHNIQUE

Du fait de l'augmentation et de la diversification des équipements, il en est résulté une croissance de la connectique des meubles en quantité en en complexité: multiplication des câblages, connexions de nature électrique et optique, manipulation délicate dans un espace disponible réduit. Il s'en suit également une augmentation du poids et des coûts (temps de cycles de maintenance élevés, puissance de calcul exigée en forte augmentation, nombre de câbles et de fonctions toujours plus importants, etc.) et une inadaptation aux nouveaux équipements présentant une autre connectique que celle initialement prévue. De plus, la dissipation de chaleur n'est plus correctement assurée car la ventilation est insuffisante avec l'augmentation du nombre de harnais et des performances visées par les nouveaux équipements.

Pour tenter de s'affranchir d'au moins certains de ces inconvénients, le document de brevet FR 2 927 222 décrit un rack électronique embarqué dans un aéronef dans lequel un « module fonction » des modules électroniques et un module d'interface des connecteurs externe de la carte-mère sont agencés de manière juxtaposée sur la face avant du rack, de sorte à faciliter l'accès aux modules électroniques et aux connecteurs externes par la face avant. Cette solution supprime la connectique en face arrière pour réaliser toutes les connexions en face avant des racks. Mais cet agencement augmente considérablement la densité de connexion des câblages sur cette face.

Il est par ailleurs connu du document de brevet FR 2 822 130 une architecture de réseau de câblage dans laquelle des modules d'interconnexion intermédiaires sont reliées entre eux par des cordons de câblage identiques et reliées à des modules d'interconnexion d'extrémité connectés à des harnais de câblage adaptés aux organes terminaux. Cette architecture permet de simplifier l'identification des connexions à réaliser mais multiplie le nombre de modules d'interconnexion en ajoutant des modules d'interconnexion intermédiaires.

### EXPOSÉ DE L'INVENTION

Dans l'état de la technique, les modules électroniques assurent la fonction complexe de conversion électronique et de conversion optoélectronique, de protection contre la foudre ou encore de filtrage séparé entre zones propre et zone sale séparées, la manipulation de ces modules générant alors des risques de détérioration, de désalignement et de salissure. En particulier, les interventions sur les modules connectées à des fibres optiques nécessitent une technicité spécialisée de branchement/débranchement de ces fibres.

L'invention vise à optimiser l'utilisation des meubles électroniques au regard de l'architecture avionique, avec une connectique interne aux meubles simplifiée et une souplesse d'adaptation en connectique externe avec les connecteurs des harnais de câblage - connectiques électroniques et/ou optiques -, ainsi que sur le plan structurel : un parcours de ventilation particulier des modules électroniques dans un châssis de configuration appropriée à la connectique et à la ventilation, tout en étant compatible avec une réduction de poids par l'utilisation de matériaux spécifiques, et un maintien spécifique du meuble sur la structure primaire d'aéronef permettant un découplage fréquentiel.

De plus, l'invention vise à apporter plus de modularité, en maitrisant les conditions d'environnement des éléments qui la composent et donc en permettant une requalification partielle de ces éléments, en particulier de la modularité aux modules électroniques ainsi qu'une simplicité et une sécurisation d'intervention.

Pour ce faire, l'invention prévoit de réaliser une fonction de conversion déportée sur une portion extrême du meuble couplée à une interconnexion modulaire amovible en liaison avec les harnais de câblage de l'architecture avionique.

Plus précisément, la présente invention a pour objet un procédé d'intégration d'un module d'interconnexion d'harnais de câblage avionique dans un meuble électronique de logement et de connexion de modules électroniques comportant une face avant, une paroi de fond présentant une face interne pourvue d'une carte de connexion auxdits modules électroniques, et deux parois latérales présentant des faces externes. Ce procédé consiste à :
- approcher, parallèlement à une paroi latérale du meuble, au moins un module d'interconnexion comportant des connecteurs auxdits harnais sur une face principale externe et un circuit de connexion sur une face latérale,
- insérer ledit module d'interconnexion dans un espace latéral d'accueil limité par la face externe de ladite paroi latérale et des bords prolongeant respectivement la paroi de fond et la face avant,
- mettre en liaison mécanique des extrémités d'une poignée montée en pivotement vertical sur ledit module avec des points fixes de la face externe de ladite face latérale,
- pivoter la poignée de sorte que lesdites extrémités de poignée tournent autour des points fixes pour avancer ledit module en translation le long de la face externe de la paroi latérale et que des circuits de connexion, agencés sur une face latérale dudit module d'interconnexion en liaison avec les connecteurs de ladite face principale externe et sur la face interne dudit bord de paroi de fond en liaison avec les connecteurs des modules électroniques de la paroi de fond, viennent se fermer l'un sur l'autre de sorte à pouvoir coupler les harnais de câblage aux modules électroniques, et
- verrouiller ledit module en position de fermeture par un serrage mécanique réversible entre ladite paroi latérale et ledit module d'interconnexion.

L'invention concerne également un meuble électronique pour aéronef, globalement parallélépipédique et équipé d'au moins un module d'interconnexion amovible comportant des connecteurs de couplage à des connecteurs de câblage destinés aux équipements de l'aéronef. Le meuble est formé d'un châssis définissant une face avant, un plateau supérieur, un plateau inférieur, une paroi de fond parallèle à la face avant, et deux parois latérales parallèles. La paroi de fond comporte une carte de fond, dite de fond de panier, apte à être connectée à un ensemble de modules électroniques destinés à être logées dans le meuble tout en restant extractibles depuis la face avant. Dans ce meuble, la paroi arrière est prolongée par des bords pourvus de connecteurs aptes à être couplés à des connecteurs agencés sur une face latérale du module d'interconnexion amovible. Les connecteurs des bords de la paroi arrière sont couplés à la carte de fond de panier par un circuit imprimé multicouche de connexion. Des moyens de fermeture et de verrouillage libérable dudit au moins un module d'interconnexion amovible sont prévus entre une poignée de module d'interconnexion et la paroi latérale du meuble contre laquelle ledit module est apte à être accolé afin de coupler, de manière réversible, les connecteurs de bord de la paroi arrière aux connecteurs de face latérale du module d'interconnexion, les connecteurs de couplage aux câblages de l'aéronef étant agencés sur une face externe dudit module d'interconnexion en liaison avec lesdits connecteurs de face latérale.

La connexion latérale libérable permet de réduire l'encombrement généré par les volumes occupés par les câblages et d'adapter les connexions électriques et optiques entre les connecteurs du module d'interconnexion amovible couplés à la connectique de câblage avion et les modules électroniques du meuble via des protocoles haut débit appropriés, en particulier des protocoles Ethernet.

Avantageusement, le meuble selon l'invention permet de transmettre des informations bidirectionnelles rapides à l'aide de fibres optiques, via une carte d'interface de conversion optique/électrique bidirectionnelle, entre les connecteurs du module d'interconnexion amovible couplés à la connectique de câblage avion et les modules électroniques du meuble, ce qui permet de s'affranchir des problèmes d'intégration.

Dans une variante avantageuse, au moins un dissipateur est monté sur une face externe du circuit imprimé multicouche afin de favoriser l'évacuation des calories par conduction ou convection.

Selon des modes de réalisation préférés :
- le meuble est essentiellement constitué par un matériau de faible densité choisi parmi des alliages métalliques à base d'aluminium et des matériaux composites à base de fibres de carbone ;
- la carte d'interface de conversion optique/électrique bidirectionnelle est intégrée dans un circuit imprimé couplé aux connecteurs des bords de paroi arrière via un connecteur multicouches de cheminement de courant fort, chaque couche du connecteur pouvant être insérée en force à une borne de connexion au circuit imprimé et au moins un dissipateur pouvant être monté en face externe du connecteur multicouche ;
- la carte d'interface de conversion optique/électrique comporte un émetteur/récepteur associé à deux reclockers d'amplification distribuée ;
- les moyens de fermeture des modules d'interconnexion comportent des crochets montés en extrémité de la poignée du module d'interconnexion, ces crochets sont montés en prise sur des ergots pour pivoter autour de ces ergots par rotation de la poignée et translater le module d'interconnexion jusqu'à atteindre les bords de prolongement de la paroi arrière en position de fermeture, et les moyens de verrouillage comportent un levier venant de la paroi latérale et apte à verrouiller la poignée en position de fermeture par une liaison serrée;
- le châssis du meuble comporte des parois intermédiaires inclinées ou verticales entre les plateaux supérieure/inférieure et respectivement au moins l'une des faces avant et/ou arrière, ces parois intermédiaires étant pourvues d'ouvertures de ventilation de sorte à permettre une mono ou bi-circulation d'air de ventilation dans le meuble entre les ouvertures des parois intermédiaires formées en liaison avec une même face ;
- le meuble possède une structure de suspension autoporteuse par bielle apte à permettre l'installation du meuble dans une zone d'accueil de l'aéronef permettant d'assurer un découplage fréquentiel.

L'invention se rapporte également à un aéronef comportant une baie avionique constituée d'un ensemble de meubles tels que définis ci-dessus et agencés de manière à permettre une circulation d'air entre eux et à transmettre des signaux de commande à des équipements électriques/électroniques de l'aéronef via des harnais de câblage électrique et/ou optique.

Selon un mode de réalisation préféré, l'aéronef comportant un fuselage, des ailes, un cockpit, un plancher de cockpit, une soute de pointe avant et une soute cargo, les meubles de la baie sont agencés dans la soute de pointe avant, la soute cargo et/ou le plancher du cockpit. L'aéronef est pourvu d'équipements électriques/électroniques répartis dans le fuselage et les ailes de l'aéronef en couplage avec les meubles de la baie via des harnais de câblage électrique et/ou optique se déployant selon une architecture intégrant la répartition des équipements dans l'aéronef.

### PRÉSENTATION DES FIGURES

D'autres données, caractéristiques et avantages de la présente invention apparaîtront à la lecture de la description non limitée qui suit, en référence aux figures annexées qui représentent, respectivement :
- les figures 1a et 1b, des vues en perspective avant et arrière de présentation générale d'un exemple de meuble électronique selon l'invention ;
- la figure 2, une vue en coupe latérale du meuble selon la figure 1 avec traçage des flux d'air de ventilation;
- la figure 3, une vue en perspective d'un exemple de module d'interconnexion selon l'invention ;
- la figure 4, des vues partielles en perspective 4a à 4c d'un exemple de module d'interconnexion amovible avec une poignée en position ouverte (vue 4a) et en position fermée avant (vue 4b) et après (vue 4c) verrouillage ;
- la figure 5, des schémas 5a à 5d d'étapes successives d'intégration du module d'interconnexion dans le meuble électronique par insertion, fermeture et verrouillage;
- la figure 6, une vue supérieure de l'évolution dans le temps (schémas 6a à 6d) d'une liaison mécanique crochet / ergot lors du pivotement de la poignée du module d'interconnexion du meuble pour fermer ce module sur le meuble;
- les figures 7a à 7c, une vue supérieure d'une architecture de répartition des équipements dans un avion en liaison avec des meubles de baie avionique implantés en soute avant (figure 7a), ainsi que des vues de cette implantation en perspective (figure 7b) et depuis l'arrière de l'avion (figure 7c);
- la figure 8, un bloc-diagramme de liaison bidirectionnelle opto-électrique selon l'invention entre les harnais de câblage avion et les modules électroniques insérés dans un meuble électronique ;
- la figure 9, un bloc-diagramme de conversion opto-électrique de bloc pour un bloc de communication selon l'invention, et
- la figure 10, une vue en coupe schématique d'une carte imprimée multicouche de conversion optoélectronique selon l'invention.

### DESCRIPTION DÉTAILLÉE

Dans le présent texte, les qualificatifs « avant », « arrière », « dessous », dessus, « supérieur », « inférieur », « vertical », horizontal », et leurs dérivés ou équivalents, se rapportent à des dispositions relatives de parties d'éléments dans une configuration d'utilisation standard, notamment par rapport à un avion au sol. Le qualificatif « latérale » se rapporte à des faces ou parois de dimension sensiblement inférieure à des faces ou parois principales de dimension sensiblement supérieure d'un même élément. Les qualificatifs « interne » et « externe » se rapportent à des faces orientées vers l'intérieur ou l'extérieur du meuble électronique selon l'invention.

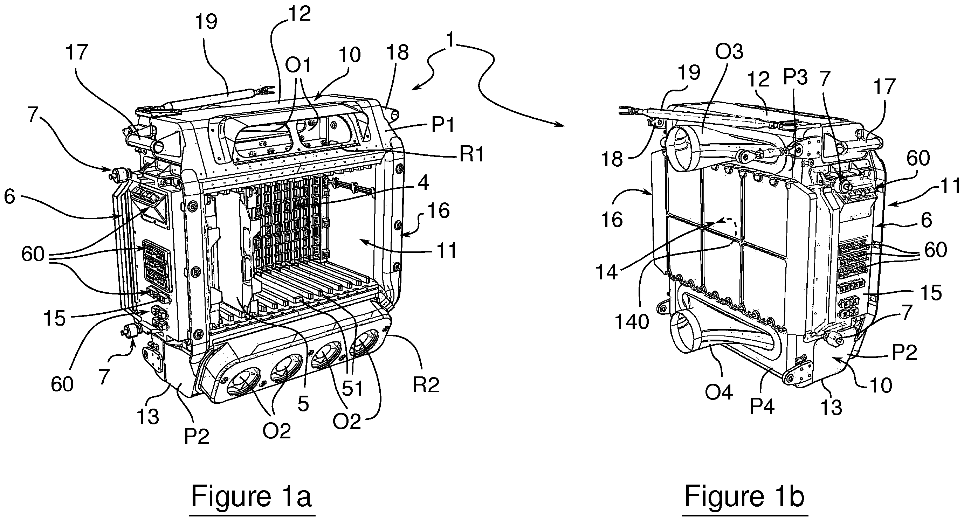

En référence aux vues en perspective avant et arrière des figures 1a et 1b, un meuble électronique 1 selon l'invention est formé d'un châssis globalement parallélépipédique 10 comportant une face avant 11, un plateau supérieur 12, un plateau inférieur 13, une paroi de fond 14 parallèle à la face avant 11, et deux parois latérales parallèles, 15 et 16.

La paroi de fond 14 comporte sur une paroi interne 140 une carte de fond 4, dite de fond de panier, connectée à un ensemble de modules électroniques, telle que le module électronique 5, montées sur des glissières 51. Les modules électroniques sont logés dans le meuble 1 parallèlement aux parois latérales 15 et 16. Les modules électroniques restent extractibles par la face avant 11. Les modules électroniques sont interchangeables sans l'aide d'outil ni de contrainte de manipulation car les harnais de câblage sont tous raccordés par le module d'interconnexion amovible. Ainsi, les durées de cycles de maintenance sont sensiblement améliorées.

Le meuble 1 possède également deux poignées mobiles de transport 17 et 18 montées en extrémité du plateau supérieur 12 ainsi qu'une bielle 19 de reprise du meuble 1. Le meuble 1 est en effet monté sur la structure primaire de l'aéronef à l'aide d'un système de suspension à bielle 19 qui permet un découplage en fréquence. De manière plus générale, de telles structures de suspension mécanique par bielles dans la zone d'accueil des meubles permet d'assurer un découplage fréquentiel de ces meubles afin de les isoler des modes propres de l'aéronef. De plus le meuble est autoporteur et ne nécessite donc pas de structure secondaire comme des chaises.

De plus, un module d'interconnexion 6 est verrouillé de manière libérable sur la paroi latérale 15 par deux leviers 7 venant de cette paroi. Des connecteurs 60 sont montés sur le module d'interconnexion 6. Ces connecteurs sont destinés à être couplés aux connecteurs des harnais de câblage des équipements réparti dans l'avion - dit câblage avion - comme cela sera détaillé ci-après.

Par ailleurs, le châssis 10 comporte deux parois inclinées intermédiaires P1 et P2 (figure 1a) entre, respectivement, les plateaux 12, 13 et la face avant 11. Ces parois P1 et P2 sont pourvues de rampes R1 et R2 d'ouvertures de ventilation, respectivement deux ouvertures O1 et quatre ouvertures O2. De plus, la paroi de fond 14 comporte (figure 1b), sur des parois intermédiaires P3 et P4 (figure 1b), en bordure de chaque plateau 12 et 13, un embout de circulation d'air, respectivement O3 et O4.

Le châssis du meuble 1 est essentiellement constitué par un matériau de faible densité, ici en alliage métallique à base d'aluminium de manière à permettre une protection contre les perturbations électromagnétiques environnementales. Il peut également être réalisé en matériau composite à base de fibres de carbone afin d'améliorer les performances en termes de masse.

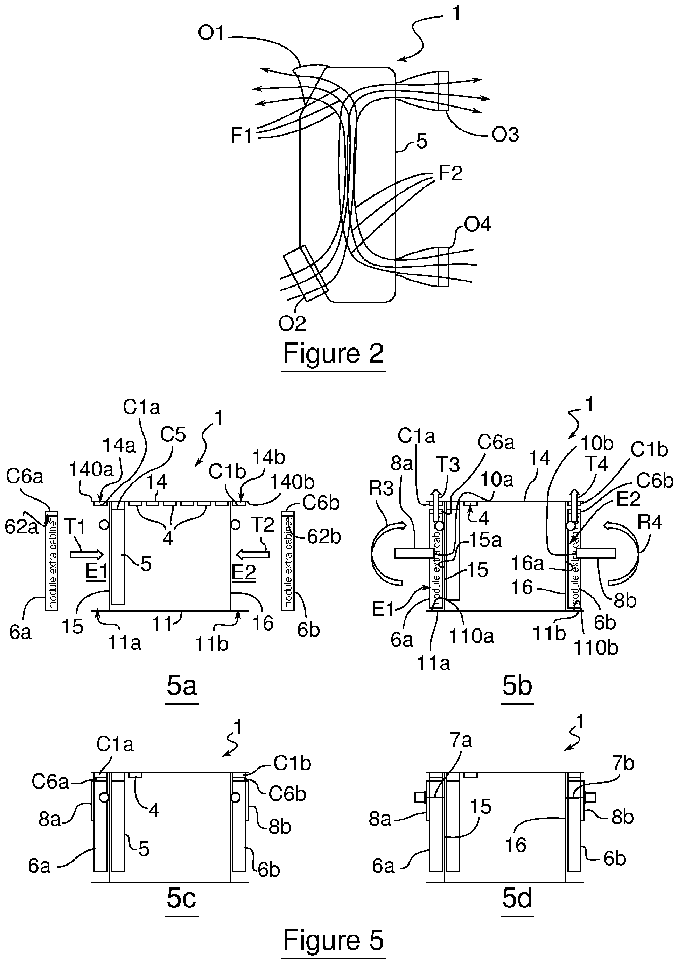

La vue en coupe latérale de la figure 2 montre la circulation de l'air dans le meuble 1, symbolisée par les ensembles de flèches F1 et F2.Selon un système de circulation d'air principal, l'air pénètre dans les ouvertures inférieures O2 pour ressortir par les ouvertures supérieures O1 (flèches F1) sur la même face avant 11 (figure 1a). Les ouvertures O1 et O2 constituent une circulation principale forcée d'air conditionné. Un autre système de circulation d'air forcée est constitué par l'ouverture inférieure O4 et l'ouverture supérieure O3, ces ouvertures O3 et O4 étant agencées sur les panneaux P3 et P4 de la paroi arrière 14 (figure 1b). Selon une mise en oeuvre avantageuse, les modules électroniques 5 peuvent être alternativement ventilés par l'un ou l'autre des deux systèmes de circulation. Selon un mode particulier, la deuxième circulation par les ouvertures O3 - O4 (flèches F2) peut constituer une circulation de secours en cas de défaillance du système principal de circulation principal par les ouvertures O1 - O2 (flèches F1).

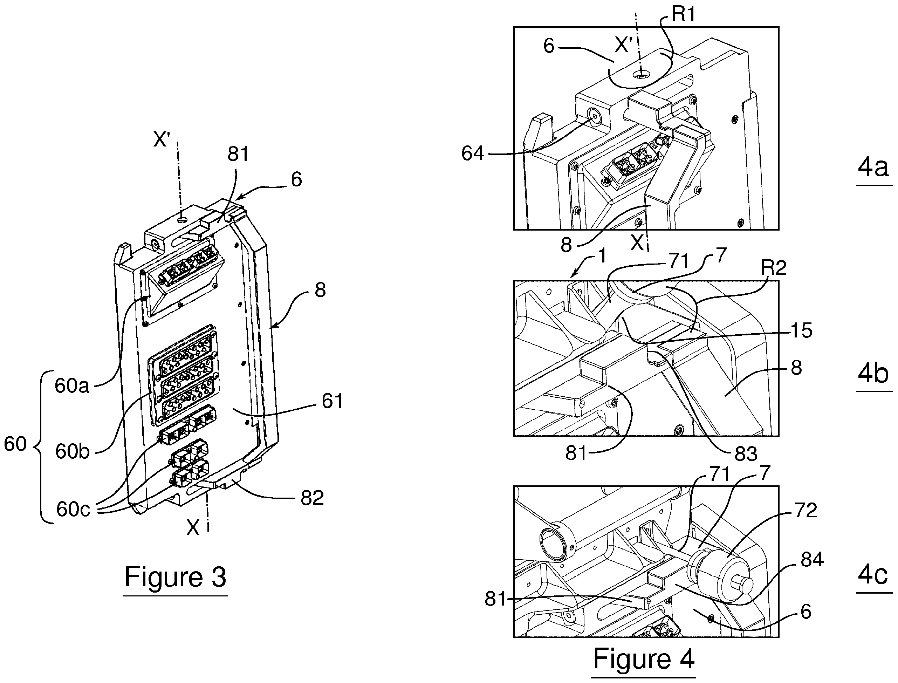

La mise en place d'un module d'interconnexion 6 est maintenant décrite en référence aux figures 3 à 5. Le module d'interconnexion 6 présente de manière détaillée, dans l'exemple de réalisation illustrée par la figure 3, les connecteurs 60 dédiés à la transmission de signaux aux harnais de câblage avion : des connecteurs 60a de communication optique, des connecteurs 60b de transmission de signaux dans un réseau Ethernet et des connecteurs 60c de câbles de puissance. Tous ces connecteurs sont montés sur la face externe 61 du module d'interconnexion 6.

Le module d'interconnexion 6 est pourvu d'une poignée globalement verticale 8, pouvant être articulée en ses deux extrémités horizontales 81 et 82 autour d'un axe vertical central X'X. Les vues partielles 4a à 4c de la figure 4 illustrent le verrouillage du module d'interconnexion 6 dans le meuble 1.

Sur la vue partielle 4a de la figure 4, la poignée 8 du module d'interconnexion 6 est illustrée en mode stockage avec la poignée 8 bloquée en position dite ouverte par une vis de blocage 64.

En référence aux vues 4a et 4b de la figure 4, ledit module 6 est en mode de fermeture puis de verrouillage dans ledit meuble 1. La position de fermeture contre la paroi latérale 15 du meuble 1 est acquise par pivotement de la poignée 8 de 90° autour de l'axe X'X (flèche circulaire R1 sur la vue 4a). Les extrémités horizontales 81 et 82 (seule l'extrémité 81 sur la vue partielle 4b) viennent alors contre la paroi latérale 15.

Le levier 7, qui est initialement en position levée sur la vue 4b, est alors abaissé (flèche R2) de sorte que son axe 71 vienne se loger dans un épaulement 83 de la poignée 8 (vue 4c de la figure 4). La tête 72, agencée à l'extrémité de l'axe 71 du levier 7, est serrée contre la face externe 84 de l'extrémité de poignée 81. Le module d'interconnexion 6 est alors verrouillé sur la paroi latérale 15 du meuble 1 (cf. figure 1a). Le verrouillage est libérable en desserrant la tête 72 et en extrayant le module d'interconnexion 6 de la paroi latérale 15 du meuble 1.

La figure 5 illustre schématiquement la cinématique d'intégration et, en cinématique inverse, la cinématique d'extraction des modules d'interconnexion 6a et 6b du meuble électronique 1 équipé de la blade 5, par des schémas 5a à 5d d'étapes successives d'insertion, de fermeture et de verrouillage.

Sur le schéma 5a, les modules 6a et 6b sont approchées du meuble 1 parallèlement (flèches de translation T1 et T2) aux parois latérales 15 et 16 de ce meuble 1, de sorte à pouvoir s'insérer dans des espaces latéraux E1 et E2. Ces espaces d'accueil sont limités par les parois latérales 15 et 16 et des bords 14a, 14b et 11a, 11b prolongeant respectivement la paroi de fond 14 et la face avant 11 du meuble 1. Les faces internes 140a et 140b des bords 14a, 14b de la paroi de fond 14 et les faces latérales 62a, 62b des modules d'interconnexion 6a, 6b sont munis de circuits de connexion ou connecteurs, respectivement C1a, C1b et C6a, C6b.

Ces circuits de connexion sont destinés à coupler les connecteurs C5 des modules électroniques 5 aux connecteurs 60a et 60b (cf. les connecteurs 60 en figure 3) aptes à être couplés à des connecteurs de harnais de câblage avion, via la carte de fond de panier 4 et les circuits de connexion C1a, C1b et C6a, C6b.

Sur le schéma 5b, les modules 6a et 6b ont été insérés dans les espaces E1 et E2 de sorte à venir contre les faces internes 110a et 110b des bords 11a et 11b de la face avant 11 et contre les faces externes 15a et 16a des parois latérales 15 et 16. Dans cette position, les extrémités des poignées 8a, 8b des modules 6a, 6b, sont en liaison mécanique avec des points fixes 10a et 10b des parois latérales 15 et 16.

Par pivotement des poignées 8a et 8b (flèches R3 et R4) autour des points fixes 10a et 10b, les modules 6a et 6b sont dirigés en translation le long des faces 15a et 16a (flèches T3 et T4) vers la paroi de fond 14 du meuble 1. La position de fermeture des modules 6a et 6b est atteinte lorsque les circuits de connexion C6a et C6b sont mis en contact avec les circuits de connexion C1a et C1b (schéma 5c). Les poignées 8a et 8b sont alors en position de fermeture.

Comme illustré par le schéma 5d, la position de fermeture des circuits est verrouillée par l'abaissement des leviers 7a et 7b, à l'image du levier 7 décrit en référence aux schémas 4b et 4c de la figure 4. Un verrouillage par un serrage mécanique réversible entre les poignées 8a, 8b des modules d'interconnexion 6a, 6b et les parois latérales 15 et 16 du meuble 1 est ainsi réalisé.

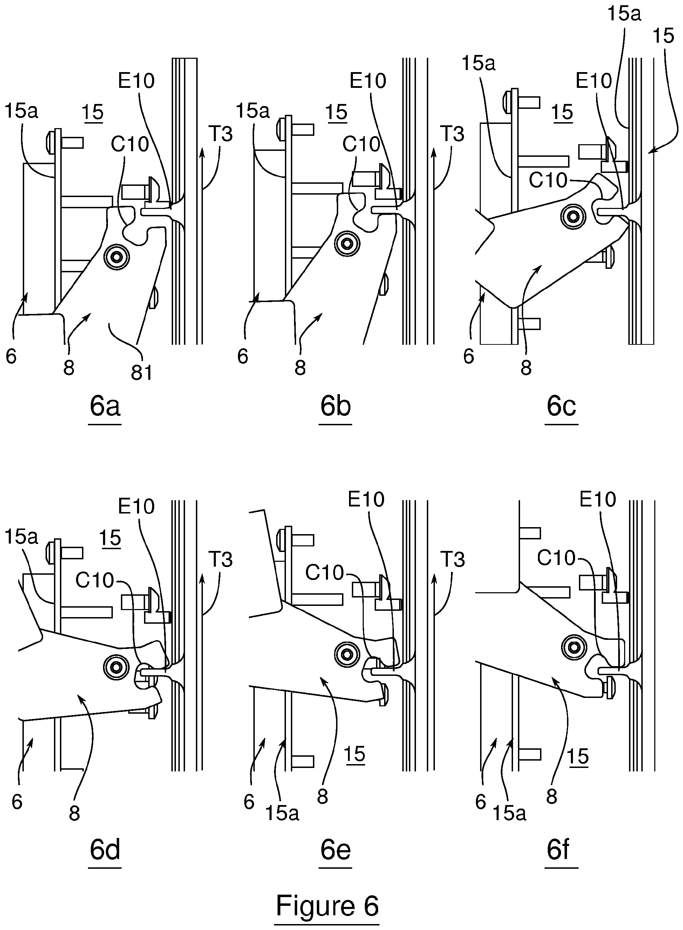

Le pivotement de la poignée 8 (8a ou 8b) du module 6 (6a ou 6b) autour de points fixes 10a ou 10b (schéma 5b de la figure 5) est plus particulièrement illustré par les schémas 6a à 6d de la vue supérieure de la figure 6. Ces schémas montrent l'évolution successive dans le temps d'une liaison mécanique entre un crochet C10, formé à l'extrémité de la partie horizontale 81 de la poignée 8 (cf. figures 4b ou 4c), et un ergot E10 solidaire de la face externe 15a de la paroi latérale 15. En suivant les schémas 6a à 6f, il apparaît que le crochet C10 vient en prise autour de l'ergot E10 qui sert de point fixe, à l'instar des points 10a ou 10b. La poignée 8 pivote autour de l'ergot E10 par la prise crochet C10 / ergot E10, et le module 6 est translatée (flèche T3 cf. schéma 5b) lors de ce pivotement pour fermer les circuits de connexion de ce module.

Bien entendu, un crochet similaire au crochet C10 est présent sur l'autre extrémité horizontale 82 de la poignée 8 (cf. figure 3) et pivote autour d'un ergot similaire à l'ergot E10 et agencé à un emplacement approprié de la face externe 15a de la paroi latérale 15.

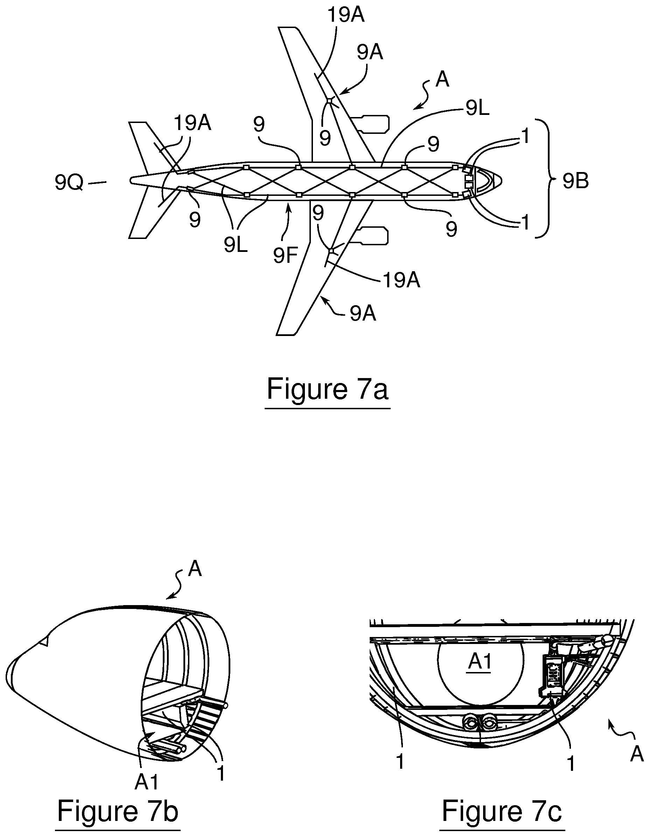

Des meubles 1 ainsi équipés sont implantés dans un avion en fonction des besoins en équipements électriques/électroniques définis par l'avionneur. La vue supérieure d'avion de la figure 7a illustre un exemple de répartition d'équipements 9 implantés dans le fuselage 9F, les ailes 9A et la queue 9Q d'un avion « A ».

Une architecture prédéfinie en fonction de l'implantation des équipements est déployée par un réseau 9L, composé d'harnais de câblage électriques et optiques 90, entre les équipements 9 et la baie 9B constituée des meubles 1 du type défini ci-dessus. Comme illustré par les vues en perspective et depuis l'arrière de l'avion A des figures 7b et 7c, les meubles 1 formant une baie avionique sont implantés, dans cet exemple, dans la soute cargo avant A1 de l'avion A.

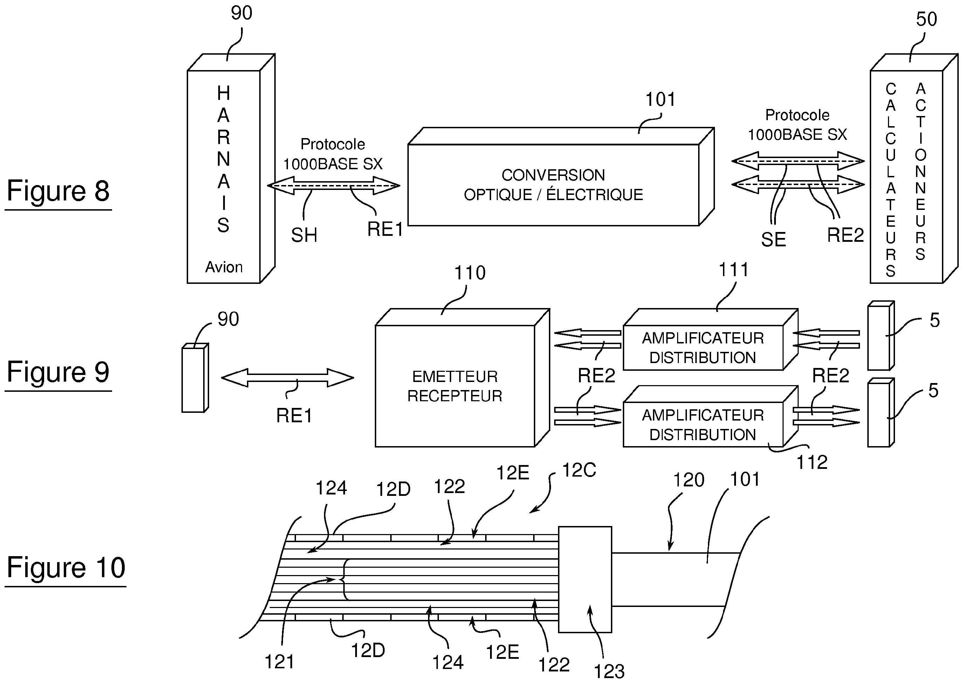

Les harnais du réseau 9L sont en partie porteurs de signaux optiques. La communication avec les modules électroniques 5 des meubles électroniques 1 (cf. figure 1a) est mise en oeuvre par le bloc-diagramme de conversion bidirectionnelle des signaux illustré par la figure 8.

Dans ce bloc-diagramme, les signaux optiques S_{H} provenant des harnais 90 sur un réseau de communication Ethernet R_{E1} de protocole « 1000BASE-SX », sont convertis en signaux électriques S_{E} via une carte d'interface de conversion optique / électrique 101. Ladite carte d'interface 101 est une carte formée dans les circuits de connexion C1a, C1b des bords 14a, 14b de la paroi de fond 14 du meuble 1 (cf. schéma 5a de la figure 5). Un exemple de module de conversion multicouche est illustré en figure 10 (voir ci-après).

Les signaux électriques sont ensuite transmis par le même circuit de connexion C1a, C1b aux calculateurs et actionneurs 50 via les connecteurs de la carte de fond de panier 4 et les connecteurs C5 des modules électroniques 5 (cf. figure 1a) - via un réseau de communication R_{E2} de fond de panier de protocole compatible avec celui du réseau R_{E1}, ici le réseau Ethernet de protocole «1000BASE-KX ».

Les transmissions sont avantageusement bidirectionnelles et rapides à l'aide de fibres optiques, ce qui permet de s'affranchir des problèmes d'intégration : des signaux de commande provenant des calculateurs et actionneurs 50 sont également transmis aux équipements concernés via les harnais 90 et à travers la carte d'interface de conversion 101, sur les réseaux de communication Ethernet R_{E2} puis R_{E1}, ici « 1000BASE-KX » et « 1000BASE-SX ».

Le bloc-diagramme de la figure 9 illustre plus précisément les composants de la carte d'interface de conversion 101 des signaux fournis par les réseaux Ethernet R_{E1} et R_{E2}. Le composant principal est un circuit d'émission/réception (ou « transceiver » en terminologie anglaise) 110. Le transceiver 110 utilisé dans l'exemple est un composant pour fibre optique de liaison multi-mode, par exemple avec une longueur d'onde de 850 nm.

Afin de délivrer un niveau de tension et de gigue («jitter» en terminologie anglaise) compatible avec le protocole « 1000BASE-KX » de fond de panier, des composants d'amplification distribuée 111 et 112 (ou « reclockers » en terminologie anglaise) sont utilisés en liaison avec le transceiver 110. L'ajout de ces reclockers permet de rétablir les niveaux de signal spécifiés pour le calculateur ou l'actionneur visée.

Le reclocker 111 transmet les signaux émis par les modules électroniques 5 vers le transceiver 110 et le reclocker 112 transmet les signaux reçus par le transceiver 110 vers les modules électroniques 5. La liaison entre le transceiver 110 et les harnais 90 de câbles optiques est assurée par le réseau Ethernet de protocole « 1000BASE-SX » R_{E1} sur fibre optique monomode bidirectionnelle.

L'invention prévoit un connecteur multicouches 12C, tel que celui représenté en vue en coupe schématique sur la figure 10, pour faire passer de la puissance dans le circuit imprimé 120, qui intègre une carte d'interface de conversion 101, à partir des connecteurs de bords de paroi arrière C1a, Cb jusqu'au connecteur de fond de panier 4 (cf. figure 5). Le connecteur multicouches 12C est connecté au circuit imprimé 120 par une borne de connexion 123. Un dissipateur 12D est monté sur les faces externes 12E de ce connecteur multicouche 12C afin de favoriser l'évacuation des calories par conduction ou convection.

Ledit circuit connecteur multicouche 12C a une épaisseur de sensiblement 105 µm par couche, avec ici un empilage spécifique d'un ensemble 121 de cinq couches pris en sandwich entre deux couches de puissance supérieures et inférieures122 et 124.

Le cheminement des courants forts est localisé sur les faces externes 12E dudit circuit 12C en respectant la symétrie dessus/dessous et en associant ces faces avec le dissipateur 12D pour éviter les problèmes de dissipation thermique et limiter les pertes en ligne.

Le cheminement des signaux rapides ou sensibles s'effectue vers l'extérieur de l'empilage 121, les couches de puissance 122 et 124 séparant les courants forts des courants rapides et sensibles.

Les couches 121, 122 et 124 du connecteur 12C sont insérés dans le bloc de connexion 123 au circuit imprimé 120 par insertion en force (« press fit » en terminologie anglaise). Ces connecteurs présentent l'avantage d'être aisément réparables.

Ce circuit connecteur multicouche présente les avantages de faire passer plus de courant fort en multipliant le nombre de connecteurs de faible épaisseur, de permettre une fabrication monobloc rapide avec une insertion/extraction sans outillage, de s'affranchir du montage/démontage d'éléments de connexion (tresse, etc.) et un gain de masse non négligeable.

L'invention n'est pas limitée aux exemples de réalisation décrits et représentés. En particulier, le meuble est dimensionné pour respecter les niveaux d'environnement les plus sévères afin de pouvoir être calibré selon un dimensionnement générique et être utilisé dans toutes les parties de l'aéronef.

Par ailleurs, la présente solution modulaire avec, en particulier, les modules d'interconnexion, peut être utilisée dans le cadre du réseau de calcul de systèmes aéroportés par assemblage dans une architecture avionique modulaire intégrée, connu sous l'appellation IMA (initiales de « Integrated Modular Avionics» en terminologie anglaise).

Avantageusement, les modules d'interconnexion peuvent être aisément configurables (par CFAO, par matrice de configuration ou équivalent) afin de répondre aux besoins des avionneurs.

## Revendications

1. Procédé d'intégration d'un module d'interconnexion (6 ; 6a, 6b) d'harnais de câblage avionique (9L) dans un meuble électronique (1) de logement et de connexion de modules électroniques (5) comportant une face avant (11), une paroi de fond (14) présentant une face interne (140) pourvue d'une carte de connexion (4) auxdits modules électroniques (5), et deux parois latérales (15, 16) présentant des faces externes (15a, 16a), **caractérisé en ce qu'**il consiste à :
- approcher, parallèlement à une paroi latérale (15, 16) du meuble (1), au moins un module d'interconnexion (6 ; 6a, 6b) comportant des connecteurs (60 ; 60a à 60c) auxdits harnais (9L) sur une face principale externe (61) et un circuit de connexion (C6a, C6b) sur une face latérale (62a, 62b) ;
- insérer ledit module d'interconnexion (6 ; 6a, 6b) perpendiculairement à ladite paroi latérale (15, 16) dans un espace latéral d'accueil (E1, E2) limité par la face externe (15a, 16a) de ladite paroi latérale (15, 16) et des bords (14a, 14b ; 11a, 11b) prolongeant respectivement la paroi de fond (14) et la face avant (11);
- mettre en liaison mécanique des extrémités (81, 82) d'une poignée (8) montée en pivotement vertical sur ledit module (6 ; 6a, 6b) sur des points fixes (10a, 10b ; E10) de la face externe (15a, 16a) de ladite paroi latérale (15, 16);
- pivoter (R3, R4) la poignée (8a, 8b) de sorte que lesdites extrémités de poignée (81, 82) tournent autour des points fixes(10a, 10b ; E10) pour avancer ledit module (6a, 6b) en translation (T3, T4) le long de la face externe (15a, 16a) de la paroi latérale (15, 16) et que des circuits de connexion (C6a, C6b), agencés sur une face latérale (62a, 62b) dudit module d'interconnexion (6a, 6b) en liaison avec les connecteurs (60 ; 60a à 60c) de ladite face principale externe (61) et avec des connecteurs (C1a, C1b) agencés sur la face interne (140a, 140b) dudit bord (14a, 14b) de paroi de fond (14) en liaison avec les connecteurs (C5) des modules électroniques (5) de la paroi de fond (14), viennent se fermer l'un sur l'autre de sorte à pouvoir coupler les harnais de câblage (9L) aux modules électroniques (5), et
- verrouiller ledit module (6 ; 6a, 6b) en position de fermeture par un serrage mécanique réversible entre ladite paroi latérale (15, 16) et ledit module d'interconnexion (6 ; 6a, 6b).

2. Meuble électronique (1) pour aéronef (A), globalement parallélépipédique et équipé d'au moins un module d'interconnexion amovible (6 ; 6a, 6b) comportant des connecteurs de couplage (60 ; 60a à 60c) à des connecteurs de câblage (9L) destinés aux équipements (9) de l'aéronef (A), le meuble (1) étant formé d'un châssis (10) définissant une face avant (11), un plateau supérieur (12), un plateau inférieur (13), une paroi de fond (14) parallèle à la face avant (11), et deux parois latérales parallèles (15, 16), la paroi de fond (14) comportant une carte de fond (4), dite de fond de panier, apte à être connectée à un ensemble de modules électroniques (5) destinés à être logées dans le meuble (1) tout en restant extractibles depuis la face avant (11), ce meuble étant **caractérisé en ce que** la paroi arrière (14) est prolongée par des bords (14a, 14b) pourvus de connecteurs (C1a, C1b) aptes à être couplés à des connecteurs (C6a, C6b) agencés sur une face latérale (62a, 62b) du module d'interconnexion amovible (6a, 6b) inséré dans un espace latéral d'accueil (E1, E2) limité par la face externe (15a, 16a) de ladite paroi latérale (15, 16) et des bords (14a, 14b ; 11a, 11b), les connecteurs des bords de la paroi arrière (C1a, C1b) étant couplés à la carte de fond de panier (4), et **en ce que** des moyens de fermeture (C10, E10) et de verrouillage libérable (7) dudit au moins un module d'interconnexion amovible (6 ; 6a, 6b) sont prévus entre une poignée (8 ; 8a, 8b) de module d'interconnexion(6 ; 6a, 6b) apte à pivoter autour de points fixes (10a, 10b; E10) et la paroi latérale (15, 16) du meuble (1) contre laquelle ledit module (6 ; 6a, 6b) est apte à être accolé afin de coupler, de manière réversible, les connecteurs de bord de la paroi arrière (C1a, C1b) aux connecteurs de face latérale du module d'interconnexion (C1a, C1b) selon le procédé de la revendication 1, les connecteurs de couplage (60 ; 60a à 60c) aux câblages (9L) de l'aéronef (A) étant agencés sur une face externe (61) dudit module d'interconnexion (6; 6a, 6b) parallèlement à la paroi latérale (15, 16) et en liaison avec lesdits connecteurs de face latérale (C6a, C6b).

3. Meuble électronique selon la revendication précédente, dans lequel le meuble (1) est essentiellement constitué par un matériau de faible densité choisi parmi des alliages métalliques à base d'aluminium et des matériaux composites à base de fibres de carbone.

4. Meuble électronique selon l'une quelconque des revendications 2 ou 3, dans lequel une carte d'interface de conversion optique/électrique bidirectionnelle (101) est intégré dans un circuit imprimé (120) couplé aux connecteurs des bords de paroi arrière couplé aux connecteurs des bords de paroi arrière (C1a, C1b) via un connecteur (12C) multicouches (121, 122, 124) de cheminement de courant fort.

5. Meuble électronique selon la revendication précédente, dans lequel chaque couche (121, 122, 124) du connecteur (12C) est insérée en force à une borne de connexion (123) au circuit imprimé (120) et au moins un dissipateur (12E) est monté en face externe du connecteur multicouche (12C).

6. Meuble électronique selon la revendication précédente, dans lequel des informations bidirectionnelles rapides sont transmises via la carte d'interface de conversion (101) entre les connecteurs du module d'interconnexion amovible (60 ; 60a à 60c) couplés à la connectique de câblage avion et les modules électroniques (5) du meuble (1) à l'aide de fibres optiques.

7. Meuble électronique selon la revendication précédente, dans lequel les connexions électriques et optiques sont réalisées entre les connecteurs du module d'interconnexion amovible (60 ; 60a à 60c) couplés à la connectique de câblage avion et les modules électroniques (5) du meuble (1) via des protocoles Ethernet appropriés.

8. Meuble électronique selon la revendication précédente, dans lequel la carte d'interface de conversion optique/électrique (101) comporte un émetteur/récepteur (110) associé à deux reclockers d'amplification distribuée (111, 112).

9. Meuble électronique selon l'une quelconque des revendications 2 à 7, dans lequel les moyens de fermeture des modules d'interconnexion (6 ; 6a, 6b) comportent des crochets (C10) montés en extrémité (81, 82) de la poignée (8) du module d'interconnexion(6 ; 6a, 6b), ces crochets (C10) sont montés en prise sur des ergots (E10) pour pivoter autour de ces ergots (E10) par rotation de la poignée (8) et translater le module d'interconnexion (6 ; 6a, 6b) jusqu'à atteindre les bords de prolongement (14a, 14b) de la paroi arrière (14) en position de fermeture, et les moyens de verrouillage comportent un levier (7) venant de la paroi latérale (15, 16) et apte à verrouiller la poignée (8) en position de fermeture par une liaison serrée.

10. Meuble électronique selon l'une quelconque des revendications 2 à 8, dans lequel le châssis (10) du meuble (1) comporte des parois intermédiaires inclinées (P1, P2) et/ou verticales (P3, P4) entre les plateaux supérieure/inférieure (12, 13) et respectivement au moins l'une des faces avant (11) et/ou arrière (14), ces parois intermédiaires (P1 à P4) étant pourvues d'ouvertures de ventilation (O1 à O4) de sorte à permettre une circulation d'air de ventilation (F1, F2) alternée dans le meuble (1) entre les ouvertures (O1, O2 ; O3, O4) des parois intermédiaires (P1 à P4) formées en liaison avec une même face (11, 14).

11. Meuble électronique selon l'une quelconque des revendications 2 à 9, dans lequel le meuble (1) possède une structure de suspension autoporteuse par bielle (19) apte à permettre l'installation du meuble (1) dans une zone d'accueil de l'aéronef permettant d'assurer un découplage fréquentiel.

12. Aéronef comportant une baie avionique (9B) constituée d'un ensemble de meubles (1) selon l'une quelconque des revendications 2 à 9, **caractérisé en ce que** les meubles (1) sont agencés de manière à permettre une circulation d'air entre eux et à transmettre des signaux de commande à des équipements électriques/électroniques (9) de l'aéronef (A) via des harnais de câblage électrique et/ou optique (9L).

13. Aéronef selon la revendication précédente, comportant un fuselage (9F), des ailes (9A), un cockpit, un plancher de cockpit, une soute de pointe avant et une soute cargo (A1), **caractérisé en ce que** les meubles (1) de la baie (9B) sont agencés dans la soute de pointe avant, la soute cargo (A1) et/ou le plancher du cockpit, et **en ce qu'**il est pourvu d'équipements électriques/électroniques (9) répartis dans le fuselage (9F) et les ailes (9A) de l'aéronef (A) en couplage avec les meubles (1) de la baie (9B) via des harnais de câblage électrique et/ou optique (9) se déployant selon une architecture intégrant la répartition des équipements (9) dans l'aéronef (A).

## Patentansprüche

1. Verfahren zum Integrieren eines Verbindungsmoduls (6; 6a, 6b) eines Avionikkabelbaums (9L) in einem Elektronikschrank (1) zum Aufnehmen und Verbinden von Elektronikmodulen (5), umfassend eine Vorderfläche (11), eine Rückwand (14), die eine Innenfläche (140) aufweist, die mit einer Karte zum Anschließen (4) an die Elektronikmodule (5) versehen ist, und zwei Seitenwände (15, 16), die Außenflächen (15a, 16a) aufweisen, **dadurch gekennzeichnet, dass** es darin besteht:
- parallel zu einer Seitenwand (15, 16) des Schranks (1) mindestens ein Verbindungsmodul (6; 6a, 6b), das Steckverbinder (60; 60a bis 60c) an die Kabelbäume (9L) an einer Hauptaußenfläche (61) und eine Anschlussschaltung (C6a, C6b) an einer Seitenfläche (62a, 62b) aufweist, anzunähern;
- das Verbindungsmodul (6; 6a, 6b) senkrecht zu der Seitenwand (15, 16) in einen seitlichen Aufnahmeraum (E1, E2) einzufügen, der von der Außenfläche (15a, 16a) der Seitenwand (15, 16) und von Rändern (14a, 14b; 11a, 11b) begrenzt ist, die jeweils die Rückwand (14) und die Vorderfläche (11) verlängern;
- Enden (81, 82) eines Griffs (8), der vertikal an dem Modul (6; 6a, 6b) befestigt ist, an festen Punkten (10a, 10b; E10) der Außenfläche (15a, 16a) der Seitenwand (15, 16) mechanisch zu verbinden;
- den Griff (8a, 8b) derart zu schwenken (R3, R4), dass sich die Enden des Griffs (81, 82) um feste Punkte (10a, 10b; E10) drehen, um das Modul (6a, 6b) entlang der Außenfläche (15a, 16a) der Seitenwand (15, 16) translatorisch vorzuschieben (T3, T4) und dass Anschlussschaltungen (C6a, C6b), die an einer Seitenfläche (62a, 62b) des Verbindungsmoduls (6a, 6b) angeordnet sind, in Verbindung mit den Steckverbindern (60; 60a bis 60c) der Hauptaußenfläche (61) und mit Steckverbindern (C1a, C1b), die an der Innenfläche (140a, 140b) des Randes (14a, 14b) der Rückwand (14) angeordnet sind, in Verbindung mit den Steckverbindern (C5) der elektronischen Module (5) der Rückwand (14) derart übereinander geschlossen werden, um die Kabelbäume (9L) mit den elektronischen Modulen (5) verbinden zu können, und
- das Modul (6; 6a, 6b) in Schließstellung durch ein reversibles mechanisches Festklemmen zwischen der Seitenwand (15, 16) und dem Verbindungsmodul (6; 6a, 6b) zu verriegeln.

2. Elektronikschrank (1) für Luftfahrzeug (A), der im Wesentlichen parallelpipedförmig ist und mit mindestens einem abnehmbaren Verbindungsmodul (6; 6a, 6b) ausgestattet ist, das Kupplungssteckverbinder (60; 60a bis 60c) an Verkabelungsverbinder (9L) aufweist, die für die Ausrüstungen (9) des Luftfahrzeugs (A) bestimmt sind, wobei der Schrank (1) aus einem Rahmen (10) gebildet ist, der eine Vorderfläche (11), eine Oberplatte (12), eine Unterplatte (13), eine Rückwand (14), die zu der Vorderfläche (11) parallel ist, und zwei parallele Seitenwände (15, 16) definiert, wobei die Rückwand (14) eine Rückplatte (4) aufweist, die Backplane genannt wird, die geeignet ist, an eine Anordnung von elektronischen Modulen (5) angeschlossen zu werden, die dazu bestimmt sind, in dem Schrank (1) untergebracht zu werden und dabei gleichzeitig von der Vorderfläche (11) herausnehmbar zu bleiben, wobei dieser Schrank **dadurch gekennzeichnet** ist, dassdie Rückwand (14) durch Ränder (14a, 14b) verlängert ist, die mit Steckverbindern (C1a, C1b) versehen sind, die geeignet sind, mit Steckverbindern (C6a, C6b) verbunden zu werden, die auf einer Seitenfläche (62a, 62b) des abnehmbaren Verbindungsmoduls (6a, 6b) ausgebildet sind, das in einen seitlichen Aufnahmeraum (E1, E2) eingesetzt ist, der von der Außenfläche (15a, 16a) der Seitenwand (15, 16) und von Rändern (14a, 14b; 11a, 11b) begrenzt ist, wobei die Steckverbinder der Ränder der Rückwand (C1a, C1b) mit der Backplane (4) verbunden sind, und dadurch, dass Mittel zum Schließen (C10, E10) und lösbaren Verriegeln (7) des mindestens einen abnehmbaren Verbindungsmoduls (6; 6a, 6b) zwischen einem Griff (8; 8a, 8b) des Verbindungsmoduls (6; 6a, 6b), der geeignet ist, sich um feste Punkte (10a, 10b; E10) zu drehen, und der seitlichen Wand (15, 16) des Schranks (1) vorgesehen sind, gegen die das Modul (6 ; 6a, 6b) geeignet ist, angefügt zu werden, um die Randsteckverbinder der Rückwand (C1a, C1b) mit den Steckverbindern der Seitenfläche des Verbindungsmoduls (C1a, C1b) nach dem Verfahren des Anspruchs 1 reversibel zu verbinden, wobei die Kupplungssteckverbinder (60; 60a bis 60c) an die Verkabelungen (9L) des Luftfahrzeugs (A) auf einer Außenfläche (61) des Verbindungsmoduls (6; 6a, 6b) parallel zu der Seitenwand (15, 16) und in Verbindung mit den Steckverbindern der Seitenfläche (C6a, C6b) angeordnet sind.

3. Elektronikschrank nach dem vorhergehenden Anspruch, wobei der Schrank (1) im Wesentlichen aus einem Material geringer Dichte gebildet ist, das ausgewählt ist aus Metalllegierungen auf Aluminiumbasis und Verbundwerkstoffen auf Basis von Kohlenstofffasern.

4. Elektronikschrank nach einem der Ansprüche 2 oder 3, wobei eine bidirektionale optisch/elektrische Schnittstellenwandlerkarte (101) in eine Leiterplatte (120) integriert ist, die mit den Steckverbindern der Ränder der Rückwand verbunden ist, die mit den Steckverbindern der Ränder der Rückwand (C1a, C1b) über einen mehrschichtigen (121, 122, 124) Steckverbinder (12C) eines Hochstromwegs verbunden ist.

5. Elektronikschrank nach dem vorhergehenden Anspruch, wobei jede Schicht (121, 122, 124) des Steckverbinders (12C) an einer Anschlussklemme (123) an der Leiterplatte (120) eingepresst ist und mindestens ein Kühlkörper (12E) auf der Außenfläche des mehrschichtigen Steckverbinders (12C) befestigt ist.

6. Elektronikschrank nach dem vorhergehenden Anspruch, wobei schnelle bidirektionale Nachrichten über die Schnittstellenwandlerkarte (101) zwischen den Steckverbindern des abnehmbaren Verbindungsmoduls (60; 60a bis 60c), die mit den Anschlüssen der Flugzeugverkabelung verbunden sind, und den elektronischen Modulen (5) des Schranks (1) mit Hilfe von optischen Fasern übertragen werden.

7. Elektronikschrank nach dem vorhergehenden Anspruch, wobei die elektrischen und optischen Verbindungen zwischen den Steckverbindern des abnehmbaren Verbindungsmoduls (60; 60a bis 60c), die mit den Anschlüssen der Flugzeugverkabelung verbunden sind, und den elektronischen Modulen (5) des Schranks (1) über geeignete Ethernet-Protokolle erfolgen.

8. Elektronikschrank nach dem vorhergehenden Anspruch, wobei die optisch/elektrische Schnittstellenwandlerkarte (101) einen Sender-Empfänger (110) aufweist, der mit zwei Reclockern zur verteilten Verstärkung (111, 112) verbunden ist.

9. Elektronikschrank nach einem der Ansprüche 2 bis 7, wobei die Mittel zum Schließen der Verbindungsmodule (6; 6a, 6b) Haken (C10) aufweisen, die am Ende (81, 82) des Griffs (8) des Verbindungsmoduls (6; 6a, 6b) montiert sind, diese Haken (C10) in Eingriff auf Spornen (E10) montiert sind, um diese Sporne (E10) herum durch Drehung des Griffs (8) zu schwenken und das Verbindungsmodul (6; 6a, 6b) bis zum Erreichen der Verlängerungsränder (14a, 14b) der Rückwand (14) in Schließstellung zu verschieben, und die Verriegelungsmittel einen Hebel (7) aufweisen, der von der Seitenwand (15, 16) kommt und geeignet ist, den Griff (8) in Schließstellung durch eine gespannte Verbindung zu verriegeln.

10. Elektronikschrank nach einem der Ansprüche 2 bis 8, wobei der Rahmen (10) des Schranks (1) geneigte (P1, P2) und/oder vertikale (P3, P4) Zwischenwände zwischen der oberen/unteren Platte (12, 13) und jeweils mindestens einer der Vorderfläche (11) und/oder Rückfläche (14) aufweist, wobei diese Zwischenwände (P1 bis P4) mit Lüftungsöffnungen (O1 bis O4) derart versehen sind, um eine abwechselnde Zirkulation der Belüftungsluft (F1, F2) in dem Schrank (1) zwischen den Öffnungen (O1, O2; O3, O4) der Zwischenwände (P1 bis P4) zu ermöglichen, die in Verbindung mit einer gleichen Seite (11, 14) gebildet sind.

11. Elektronikschrank nach einem der Ansprüche 2 bis 9, wobei der Schrank (1) eine selbsttragende Aufhängestruktur durch Pleuelstange (19) besitzt, die geeignet ist, die Installation des Schranks (1) in einem Aufnahmebereich des Luftfahrzeugs zu ermöglichen, wodurch ein häufiges Entkoppeln sichergestellt werden kann.

12. Luftfahrzeug, umfassend eine Avionik-Bucht (9B), die aus einer Baugruppe von Schränken (1) nach einem der Ansprüche 2 bis 9 gebildet ist, **dadurch gekennzeichnet**, die Schränke (1) derart ausgebildet sind, um eine Luftzirkulation zwischen ihnen zu ermöglichen und um Steuersignale an elektrische/elektronische Anlagen (9) des Luftfahrzeugs (A) über elektrische Kabelbäume und/oder Glasfaserkabelbäume (9L) zu übertragen.

13. Luftfahrzeug nach dem vorhergehenden Anspruch, umfassend einen Rumpf (9F), Tragflächen (9A), ein Cockpit, einen Cockpitboden, einen vorderen Frachtraum an der Spitze und einen Laderaum (A1), **dadurch gekennzeichnet, dass** die Schränke (1) der Bucht (9B) in dem vorderen Frachtraum an der Spitze, dem Laderaum (A1) und/oder dem Boden des Cockpits angeordnet sind, und dadurch, dass es mit elektrischen/elektronischen Anlagen (9) versehen ist, die in dem Rumpf (9F) und den Tragflächen (9A) des Luftfahrzeugs (A) in Verbindung mit den Schränken (1) der Bucht (9B) über elektrische Kabelbäume und/oder Glasfaserkabelbäume (9) verteilt sind, die sich nach einer Architektur entfalten, die die Verteilung der Anlagen (9) in dem Luftfahrzeug (A) einbindet.

## Claims

1. A method for integrating an avionic cabling assembly (9L) interconnection module (6; 6a, 6b) in an electronic cabinet (1) for housing and connecting electronic modules (5) comprising a front face (11), a back panel (14) having an internal face (140) provided with a card for connection (4) to said electronic modules (5) and two lateral walls (15, 16) having external faces (15a, 16a), **characterized in that** it consists of:
- moving, parallel with a lateral wall (15, 16) of the cabinet (1), at least one interconnection module (6; 6a, 6b) comprising connectors (60; 60a to 60c), towards said assemblies (9L) on a principal external face (61) and a connection circuit (C6a, C6b) on a lateral face (62a, 62b);
- inserting said interconnection module (6; 6a, 6b) perpendicularly to said lateral wall (15, 16) in a lateral housing space (E1, E2) limited by the external face (15a, 16a) of said lateral wall (15, 16) and edges (14a, 14b; 11a, 11b) respectively extending the back panel (14) and the front face (11);
- mechanically connecting the ends (81, 82) of a handle (8) mounted, such that it pivots vertically on said module (6; 6a, 6b), on fixed points (10a, 10b; E10) on the external face (15a, 16a) of said lateral wall (15, 16);
- pivoting (R3, R4) the handle (8a, 8b) in such a way that said handle ends (81, 82) rotate about fixed points (10a, 10b; E10) in order to move said module (6a, 6b) in translation (T3, T4) along the external face (15a, 16a) of the lateral wall (15, 16) and that connection circuits (C6a, C6b), arranged on a lateral face (62a, 62b) of said interconnection module (6a, 6b) in liaison with the connectors (60; 60a to 60c) of said principal external face (61) and with connectors (C1a, C1b) arranged on the internal face (140a, 140b) of said edge (14a, 14b) of back panel (14) in liaison with the connectors (C5) of the electronic modules (5) of the back panel (14), become closed one upon the other so that it is possible to couple the cabling assemblies (9L) with the electronic modules (5), and
- locking said module (6; 6a, 6b) in the closed position by reversible mechanical clamping between said lateral wall (15, 16) and said interconnection module (6; 6a, 6b).

2. An overall box-shaped electronic cabinet (1) for aircraft (A), equipped with at least one detachable interconnection module (6; 6a, 6b) comprising connectors (60; 60a to 60c) for coupling to cabling connectors (9L) intended for equipment (9) of the aircraft (A), the cabinet (1) being formed from a chassis (10) defining a front face (11), an upper panel (12), a lower panel (13), a back panel (14) parallel with the front face (11), and two parallel lateral walls (15, 16), the back panel (14) comprising a back card (4), called a back panel, able to be connected to a set of electronic modules (5) intended to be housed in the cabinet (1) whilst remaining extractable from the front face (11), this cabinet being **characterized in that** the rear wall (14) is extended by edges (14a, 14b) provided with connectors (C1a, C1b) able to be coupled with connectors (C6a, C6b) arranged on a lateral face (62a, 62b) of the detachable interconnection module (6a, 6b) inserted in a lateral housing space (E1, E2) limited by the external face (15a, 16a) of said lateral wall (15, 16) and edges (14a, 14b; 11a, 11b), the connectors (C1a, C1b) of the edges of the rear wall being coupled with the back panel card (4) and **in that** means of closing (C10, E10) and releasably locking (7) said at least one detachable interconnection module (6; 6a, 6b) are provided between an interconnection module (6; 6a, 6b) handle (8; 8a, 8b) able to pivot about fixed points (10a, 10b; E10) and the lateral wall (15, 16) of the cabinet (1) against which said module (6; 6a, 6b) is able to be placed in order to couple, in a reversible manner, the edge connectors (C1a, C1b) of the rear wall with the lateral face connectors (C1a, C1b) of the interconnection module, according to the method in claim 1, the connectors (60; 60a to 60c) for coupling with the cabling (9L) of the aircraft (A) being arranged on an external face (61) of said interconnection module (6; 6a, 6b) parallel with the lateral wall (15, 16) and in liaison with said lateral face connectors (C6a, C6b).

3. The electronic cabinet as claimed in the preceding claim, **characterized in that** the cabinet (1) is essentially constituted by a low-density material chosen from aluminum-based metal alloys and composite materials based on carbon fibers.

4. The electronic cabinet as claimed in any one of claims 2 and 3, and in which a bidirectional optical/electric conversion interface card (101) is integrated in a printed circuit (120) coupled to the connectors of the edges of the rear wall coupled to the connectors of the edges of the rear wall (C1a, C1b) via a multi-layer (121, 122, 124) connector (12C) for conveying heavy current.

5. The electronic cabinet as claimed in the preceding claim, in which each layer (121, 122, 124) of the connector (12C) is inserted by force in a terminal (123) for connection to the printed circuit (120) and at least one dissipator (12E) is mounted on an external face of the multi-layer connector (12C).

6. The electronic cabinet as claimed in the preceding claim, in which fast bidirectional information is transmitted via the conversion interface card (101), between the connectors of the detachable interconnection module (60; 60a to 60c) coupled to the aircraft cabling connector technology and the electronic modules (5) of the cabinet (1) using optical fibers.

7. The electronic cabinet as claimed in the preceding claim, in which the electric and optical connections are made between the connectors of the detachable interconnection module (60; 6a to 60c) coupled to the aircraft cabling connector technology and the electronic modules (5) of the cabinet (1) via appropriate Ethernet protocols.

8. The electronic cabinet as claimed in the preceding claim, in which the optical/electric conversion interface card (101) comprises a transmitter/receiver (110) associated with two distributed amplification reclockers (111, 112).

9. The electronic cabinet as claimed in any one of claims 2 to 7, in which the means of closing the interconnection modules (6; 6a, 6b) comprise hooks (C10) mounted at the ends (81, 82) of the handle (8) of the interconnection module (6; 6a, 6b), these hooks (C10) are mounted engaged on lugs (E10) in order to pivot about these lugs (E10) by rotation of the handle (8) and to move the interconnection module (6; 6a, 6b) in translation until it reaches the extended edges (14a, 14b) of the rear wall (14) in the closed position, and the locking means comprise a lever (7) coming from the side wall (15, 16) and able to lock the handle (8) in the closed position by clamped connection.

10. The electronic cabinet as claimed in any one of claims 2 to 8, in which the chassis (10) of the cabinet (1) comprises intermediate inclined (P1, P2) and/or vertical walls (P3, P4) between the upper and lower panels (12, 13) and respectively at least one of the front (11) and/or rear (14) faces, these intermediate walls (P1 to P4) being provided with ventilation openings (O1 to O4) in order to allow an alternating flow of ventilation air (F1, F2) in the cabinet (1) between the openings (O1, O2; O3, O4) of the intermediate walls (P1 to P4) formed in liaison with a same face (11, 14).

11. The electronic cabinet as claimed in any one of claims 2 to 9, in which the cabinet (1) has a self-supporting suspension by rods structure (19) able to allow the installation of the cabinet (1) in a housing area of the aircraft making it possible to allow periodic decoupling.

12. An aircraft comprising an avionic bay (9B) constituted by a set of cabinets (1) as claimed in any one of claims 2 to 9, **characterized in that** the cabinets (1) are arranged in such a way as to allow a flow of air between them and to transmit control signals to electric/electronic equipment (9) of the aircraft (A) via electric and/or optical cabling assemblies (9L).

13. The aircraft as claimed in the preceding claim, comprising a fuselage (9F), wings (9A), a cockpit, a cockpit floor, a nose hold and a cargo hold (A1), **characterized in that** the cabinets (1) of the bay (9B) are arranged in the nose hold, the cargo hold (A1) and/or the floor of the cockpit, and **in that** it is provided with electric/electronic equipment (9) distributed in the fuselage (9F) and the wings (9A) of the aircraft (A) and coupled with the cabinets (1) in the bay (9B) via electric and/or optical cabling assemblies (9) spread out according to an architecture integrating the distribution of the equipment (9) in the aircraft (A).
